# EUROPÄISCHE PATENTSCHRIFT

(11) **EP 3 058 400 B1**
(45) Veröffentlichungstag und Bekanntmachung des Hinweises auf die Patenterteilung: **31.07.2024**
(21) Anmeldenummer: 14790545.9
(22) Anmeldetag: 16.10.2014
(51) Int. Cl.: G02B 5/28, C23C 14/00, C23C 14/08, C23C 14/10, H01J 37/34

(54) **VERFAHREN UND VORRICHTUNG ZUR HERSTELLUNG UNIFORMER SCHICHTEN AUF BEWEGTEN SUBSTRATEN UND DERART HERGESTELLTE SCHICHTEN**
METHOD AND DEVICE FOR PRODUCING UNIFORM LAYERS ON MOVING SUBSTRATES, AND LAYERS PRODUCED IN SUCH A MANNER
PROCÉDÉ ET DISPOSITIF POUR LA PRODUCTION DE COUCHES UNIFORMES SUR DES SUBSTRATS EN MOUVEMENT ET COUCHES AINSI PRODUITES

(30) Priorität: 16.10.2013 DE 102013221029
(43) Veröffentlichungstag der Anmeldung: 24.08.2016
(73) Patentinhaber: Fraunhofer-Gesellschaft zur Förderung der angewandten Forschung e.V., 80686 München (DE)
(72) Erfinder: VERGÖHL, Michael, 38162 Cremlingen (DE); RADEMACHER, Daniel, 38110 Braunschweig (DE); ZICKENROTT, Tobias, 38110 Braunschweig (DE)
(74) Vertreter: Pfenning, Meinig & Partner mbB
(86) Internationale Anmeldenummer: PCT/EP2014/072257
(87) Internationale Veröffentlichungsnummer: WO 2015/055781

(56) Entgegenhaltungen:
- EP-A1- 2 549 521
- EP-B1- 0 320 016
- DE-A1- 102004 004 569
- US-A- 4 933 063
- US-A1- 2012 228 122
- KAREN D. HENDRIX ET AL: "<title>Demonstration of narrowband notch and multi-notch filters</title>", PROCEEDINGS OF SPIE, vol. 7067, 28 August 2008 (2008-08-28), pages 706702, XP055114099, ISSN: 0277-786X, DOI: 10.1117/12.795498
- KIRSTEN I. SCHIFFMANN ET AL: "Characterization of 31 nonperiodic layers of alternate SiO 2 /Nb 2 O 5 on glass for optical filters by SIMS, XRR, and ellipsometry", SURFACE AND INTERFACE ANALYSIS, vol. 45, no. 1, 31 May 2012 (2012-05-31), pages 490 - 493, XP055162499, ISSN: 0142-2421, DOI: 10.1002/sia.5046
- VERGÖHL MICHAEL ET AL: "Towards ultra-precise optical interference filters on large area: computational and experimental optimization of the homogeneity of magnetron-sputtered precision optical coatings", PROCEEDINGS OF SPIE, S P I E - INTERNATIONAL SOCIETY FOR OPTICAL ENGINEERING, US, vol. 8450, 13 September 2012 (2012-09-13), pages 84502J - 84502J, XP060028581, ISSN: 0277-786X, DOI: 10.1117/12.926758
- ADAM BADEEN ET AL: "<title>Advanced optical coatings for telecom and spectroscopic applications</title>", PROCEEDINGS OF SPIE, vol. 7101, 19 September 2008 (2008-09-19), pages 71010H, XP055162477, ISSN: 0277-786X, DOI: 10.1117/12.797949
- VERGÖHL MICHAEL ET AL: "Progress on optical coatings deposited with dual rotatable magnetrons in a sputter up system", SURFACE AND COATINGS TECHNOLOGY, vol. 241, 23 November 2013 (2013-11-23), pages 38 - 44, XP028617119, ISSN: 0257-8972, DOI: 10.1016/J.SURFCOAT.2013.11.033

## Beschreibung

Die Erfindung bezieht sich auf die Abscheidung optischer Präzisionsschichten mit hoher Uniformität, Präzision, Partikelfreiheit und geringer Absorption auf dem Substrat. Dazu wird ein Verfahren und eine Vorrichtung vorgeschlagen. Ansatz ist die Verwendung von Targetmaterialien sowie ggf. von Oberflächen im Sputterbereich. Es wird eine besonders hohe Uniformität als auch eine besonders geringe Restabsorption mit diesen Materialien erreicht. Die Erfindung eignet sich zur Herstellung optischer Dünnschichtfilter, wie sie beispielsweise in der Laser-Materialbearbeitung, Laserkomponenten, optischen Sensoren für die Messtechnik, oder in der medizinischen Diagnostik zum Einsatz kommen.

Optische Filter werden oft mit einer hohen Anzahl von Schichten abgeschieden und die Gesamtschichtdicke liegt dann über einige Mikrometer, bis teilweise über 10 Mikrometer oder noch mehr. Geringe Verluste in der Schicht sind dann entscheidend. Es müssen sowohl Streuverluste als auch Verluste durch Unterstöchiometrie vermieden werden. Das hier vorgeschlagene Verfahren ermöglicht ebenfalls die Abscheidung sehr verlustarmer und auch defektfreier Schichten.

Optische Präzisionsfilter sind eine Schlüsselkomponente vieler industrieller Produkte der optischen Technologien. Anwendungen reichen von der Lasertechnik über Medizin- und Bioverfahrenstechnik, Display- und Automobil- bis zur Solarindustrie. Bedingt durch die stetig steigenden technologischen Anforderungen sowie durch die zunehmende Konkurrenz aus Billiglohnländern wächst die Nachfrage nach besseren, flexibleren und zugleich wirtschaftlichen Produktionsverfahren für optische Präzisionsbeschichtungen. Heutige Verfahren kommen zunehmend an technologische Grenzen bei besonders hohen Anforderungen: Steigender Ausschuss, zu geringe Langzeitstabilität sowie die Nicht-Realisierbarkeit von technischen Spezifikationen mindert die Wirtschaftlichkeit und behindert die Einführung neuer Produkte.

Insbesondere Magnetron-Sputterquellen haben sich in den letzten Jahren als äußerst leistungsfähige Beschichtungswerkzeuge erwiesen um Dünnschichtsysteme im industriellen Maßstab zu fertigen. Insbesondere für optische Beschichtungen und den damit verbundenen Ansprüchen an Schichtuniformität und -homogenität, Stöchiometrie und Partikelfreiheit stellen Targets mit beigemischter Reaktivgaskomponente eine sehr gute Möglichkeit dar die geforderten Kriterien zu erfüllen. Durch die Nutzung von Targets mit eingebauter Reaktivgaskomponente, lässt sich die Stabilität des Prozesses, der wesentlich durch das Getterverhalten der Oberflächen und dem sich dadurch ausbreitenden Konzentrationsgefüge der Reaktivgaskomponente bestimmt wird, verbessern. Gerade bei Beschichtungskonzepten, die auf Drehtelleranordnungen basieren, können Standzeiten und Stabilität des Beschichtungsprozesses so deutlich erhöht werden.

Optische Dünnschichtsysteme, die das Prinzip der Interferenz nutzen, z.B. für die Lasertechnik, Medizin- und Bioverfahrenstechnik, Display- und Automobiltechnik, der Solarindustrie bis hin zu Weltraumtechnologien, erfordern hierbei das möglichst präzise Einhalten der spezifizierten Filtereigenschaften sowie geringe Absorptionen und Verluste im optischen Filter. Um insbesondere die geforderten minimalen Verluste einzuhalten ist es unabdingbar Stöchiometrie der Schichten genau und stabil einstellen zu können, da diese die Ursache für Streuung, Absorption und geringe Zerstörschwellen im Bereich der Laseranwendungen sein können.

Nicht nur die guten Eigenschaften der Schichten zu erreichen ist notwendig, sondern diese auch mit möglichst großer Fläche und mit großer Reproduzierbarkeit. Bei der Schichtherstellung kommt es besonders in der Präzisionsoptik auf sehr genau einstellbare Schichtdicken an. Die Schichtdickenverteilung auf dem Substrat bedarf eines besonders stabilen und gut konditionierten Prozesses.

Durch stetig wachsende Anforderungen standen Beschichtungsverfahren praktisch immer an der Grenze des technisch Machbaren. Die zu erreichenden Schichteigenschaften erfordern dabei oft einander widersprechende Prozessbedingungen. So korreliert eine hohe Schichthärte und stabile Beschichtung mit sehr glatter Oberfläche (ohne Temperaturabhängigkeit der Kanten) in der Regel mit kompressiven Schichtspannungen, während Schichten ohne Stress meist rau sind und eine starke Temperatur- und Feuchteabhängigkeit (spektraler Shift) zeigen.

Frühzeitig erkannte man die große Bedeutung des Zusammenhanges von energetischen Teilchen (Ionen, Neutralteilchen, Radikale) mit dem Schichtwachstumsprozess und somit den Schichteigenschaften: Die Morphologie und damit auch die Schichteigenschaften in Plasma-Beschichtungsprozessen sind wesentlich durch die Art und die Energieverteilung sowohl von Ionen als auch von Neutralteilchen bestimmt, wobei die Teilchenenergien von Ionen und Neutralteilchen je nach Plasmabedingungen stark variieren können. Schichtspannungen lassen sich im Rahmen des Atomic-Peening-Modells durch den Beschuss der Schicht mit energetischen Teilchen erklären. Auch negativ geladene Sauerstoff-Ionen, wie sie in Reaktivprozessen besonders auftreten, können das Schichtwachstum erheblich beeinflussen.

Zur Herstellung von präzisionsoptischen Schichten wird heute zunehmend das Magnetron-Sputtern eingesetzt. Mit diesem Verfahren lassen sich dichte, absorptionsarme Schichten realisieren. Gegenüber klassischen Verfahren wie dem Aufdampfen hat das Magnetronsputtern eine hohe Prozessstabilität. Insbesondere kann der Prozess auch automatisiert werden, wobei ein Transfer der zu beschichtenden Proben über eine Schleuse erfolgen kann. Das Schleusenprinzip ermöglicht es, eine besonders gute Sauberkeit der Oberfläche zu erreichen, da in herkömmlichen Batch-Anlagen nach jeder Charge belüftet werden muss, was dazu führt, das Beschichtungen auf Kammerwänden etc. durch Feuchteeintrag abplatzen können. In Systemen mit Schleusen kann die Prozesskammer dauerhaft unter Vakuum gehalten werden, was sehr saubere und stabile Prozesse ermöglicht.

Eingesetzt werden RF-angeregte Prozesse, bei denen die Leistung mit typischerweise 13,56 MHz eingetragen wird. Mit RF Prozessen können auch isolierende Sputtertargets verwendet werden. Bevorzugt werden heute aber auch gepulste Prozesse (mit Frequenzen im Mittelfrequenzbereich, 10-300 KhZ, bevorzugt um 45 KHz). Diese sind kostengünstiger und können gut aufskaliert werden. Stell man unter Verwendung von metallischen Targets oxidische Verbindungsschichten her, spricht man von reaktiven Sputterprozessen.

Plasmen, basierend auf Magnetronentladungen, bestehen in der Regel zu mehr als 99% aus nicht-ionisierten Teilchen. Diese können hohe Energien aufweisen und tragen daher stark zu Schichtspannungen bei. Sie lassen sich indirekt, beispielsweise durch Veränderung des Magnetfeld-Designs oder durch die Verwendung alternativer Sputtergase beeinflussen. Reflektierte Argon-Teilchen wurden als Grund für Schichtstress von Windischman (Windischmann, H. (1992). "Intrinsic Stress in Sputter-Deposited Thin Films." Critical Reviews in Solid State and Materials Sciences 17(6): 547-596) an AIN-Schichten sowie an BC-Schichten von Jacobssohn (L. G. Jacobsohn, R. D. Averitt, and M. Nastasi, "The role of trapped Ar atoms in the mechanical properties of boron carbide films deposited by dc-magnetron sputtering, J. Vac. Sci. Technol. A 21 (5) (2003), p. 1639) erkannt. Andere Gase (z.B. das leichtere Krypton statt Argon) führt zwar zu geringeren Spannungen, aber ebenfalls zu geringeren Härten.

Auch die optischen Eigenschaften werden durch das Teilchen-Bombardement der wachsenden Schicht beeinflusst: In fluoridischen Schichten wurde eine erhöhte Absorption durch den Einbau von Argon in die Schicht gefunden. Die Möglichkeit der Beeinflussung der lonen- und Neutralteilchenenergien und deren Dichte sind von hohem Interesse für die Herstellung und Optimierung optischer Schichten. Energetische Neutralteilchen, die auf die wachsende Schicht treffen, können beispielsweise Frenkel-Defekte induzieren. Nanodefekte spielen eine immer größere Rolle bei Hochleistungsoptiken für Ultrakurzpuls- oder UV-Laseranwendungen. In Beschichtungsprozessen, bei denen Verbindungsschichten abgeschieden werden (Metalloxide, Nitride etc.) entstehen aber auch Defekte als Partikel, beispielsweise indem sich auf Oberflächen in der Anlage dicke parasitäre Verbindungsschichten niederschlagen. Diese Schichten sind oft nur lose gebunden und können abplatzen, sobald Luft mit Wasseranteilen an die Oberfläche kommt oder auch wenn die Schichtdicke zu groß wird. In diesem Fall bilden sich Partikel, die das Substrat kontaminieren können. Das Magnetron selber ist eine Quelle für Partikel, insbesondere in reaktiven Beschichtungsprozessen.

Reaktive Sputterprozesse haben prinzipiell zwei stabile Arbeitsbereiche, den Oxide-Mode und den Metallic-mode. Im oxide mode ist das Target mit einer Oxidschicht bedeckt, und die Rate ist auf dem Substrat klein. Die Schicht ist transparent (stöchiometrisch). Im Metal mode ist das Target metallisch, die Rate hoch und die Schicht metallisch. Um transparente Schichten mit hoher Rate zu realisieren, muss der reaktive Sputterprozess dynamisch auf einen mittleren, bestimmten Reaktivgas-Partialdruck eingestellt (geregelt) werden, was beispielsweise mittels Messung des Sauerstoff-Partialdruckes mittels Lambdasonde oder auch optisch mittels Plasma-Emissionsmessung möglich ist. Man bezeichnet diesen Arbeitspunkt als "Transition Mode".

Herausforderungen im Bereich der reaktiven Magnetronsputtertechnik liegen darin, dass sich, je nach Targetmaterial, und dessen Herstellungsverfahren verschiedene Prozessparameter ergeben, die für die Herstellung optischer Präzisionsbeschichtungen geeignet sind.

Beispielsweise werden metallische Targets in der Regel im sogenannten "Transition Mode" betrieben. Hier befindet sich das Target permanent in einem metallischen, oxidfreien Zustand, während im Prozessraum genügend Sauerstoff für die Oxidation der wachsenden Schicht vorhanden sein muss.

Damit lässt sich eine Kombination aus stöchiometrischen Schichten und hoher Rate erreichen. Dieser Prozesspunkt kann entweder durch eine geeignete Regelung stabilisiert werden, wodurch der Sauerstoff-Partialdruck konstant gehalten wird. Durch den Einsatz von Doppelmagnetron-Anordnungen mit bipolarer Anregung konnten zudem auch bessere Langzeitstabilität aufgrund der "nichtverschwindenden Anode" und höhere Plasmadichten in Kombination mit dichteren (aber auch stärker verspannten) Schichten gewährleistet werden.

In US 5,525,199 wird eine Methode zur Herstellung partikelarme Schichten mit sehr geringen Verlusten vorgestellt. Dort werden diese Eigenschaften durch das Betreiben der Magnetronentladung bei sehr geringem Prozessdruck bei zugleich großem Abstand zwischen Target und Substrat erreicht. Gleiches gilt für das Patent US 5,851,365 bei dem der Abstand mit 40cm (16") immer noch deutlich größer ist als üblich, der normalerweise weniger als 10 cm beträgt, vorzugsweise zwischen 7 und 9 cm.

Bei der Regelung von reaktiven Magnetron-Sputterprozessen ist je nach Pumpverhältnissen und Konfiguration der Komponenten eine Zeitkonstante von etwa 20-30 Millisekunden erreichbar. Nachteil dieser dynamischen Stabilisierung ist, dass selbst bei optimaler Regelung geringe Restschwankungen der Prozessbedingungen und damit auch der Stöchiometrie der Schicht nicht zu vermeiden sind, die zu geringen Inhomogenitäten und damit zu Verlustmechanismen führen können, die besonders bei sehr hochwertigen optischen Schichten Probleme bereiten können. Oft findet man auch Effekte, daß das Sputtertarget nicht symmetrisch läuft. Auf der einen Seite des Targets brennt dieses metallisch bei hoher Rate, während es auf der anderen oxidisch läuft mit kleiner Rate. Da ein mit Oxidschicht belegtes Target weniger Getterwirkung für die Metallatome hat, erhöht sich dort weiter der Reaktivgas-Partialdruck. Da die Sputterausbeute für Oxide im Allgemeinen kleiner ist als für Metalle, sinkt dort die Rate. Auf der metallischen Seite findet der entgegengesetzte Mechanismus statt: Aufgrund des dort metallischen Targets ist die Getterwirkung hoch, so dass der Sauerstoffpartialdruck kleiner wird und die Rate dort ansteigt. Mehr Sauerstoff wird dort verbraucht. Letztlich führt die reaktive Prozessführung dazu, dass die Verteilung kippt. Zwar kann man durch die Verwendung von mehreren Messstellen (insbesondere optische Plasma-Emissions-Sensoren) die Verteilung aktiv regeln, jedoch ist dieses Verfahren begrenzt, wenn es auf eine extrem hohe Uniformität von besser als ca. 99% bis über 99.8% ankommt, da die Sensoren dann nur begrenzt empfindlich sind.

Daher wird auch der Ansatz des Sputterns von sehr dünnen, substöchiometrischen oder metallischen Schichten betrieben, die separat in einem Sauerstoffplasma nachoxidiert werden. Der Vorteil bei dieser Methodik liegt ebenfalls in der weitgehend metallischen Oberfläche des Targets. Dieses Herstellungsverfahren bedingt eine Anlagentechnik mit separater Plasmaquelle und einer Substratbewegung im Prozess. Jeweils sehr dünne Schichten (0,1-5Å effektive optische Dicke) werden dabei oxidiert. Für dieses Verfahren eignen sich insbesondere Drehtelleranlagen, da hier die Stationen für die Beschichtung und die Station für die Nachoxidation nacheinander angefahren werden können. In DE 103 47521 A1 wird ein solches Verfahren beschrieben.

Hier werden zunächst substöchiometrische Schichten mit vernachlässigbaren optischen Verlusten unter Zugabe einer Reaktivgaskomponente zu dem abgestäubten Material auf einem Bauteil (z.B. Glas) abgeschieden und die Plasmaquelle wird zur vollständigen Oxidation dieser Schicht verwendet.

In EP 0409451, US 5,225,057, OCLI, "Process for depositing optical films on both planar and non-planar substrates", US 5,798,027 und DE 690 33 441 T2 wird eine metallische Beschichtung durchgeführt mit einer Nachoxidation im Plasma. Eingesetzt wird dort eine Mikrowellen-Plasmaquelle, die mit Sauerstoff (bzw. Reaktivgas) und einem Neutralgas (Argon) oder einer Mischung davon betrieben werden kann.

Eine hohe Trennung der Prozessräume von Oxidationsbereich (Plasmaquelle) und Magnetron ist zu bevorzugen, damit das Magnetron kein oder möglichst wenig Sauerstoff "sieht".

Die DE 10 2004 004 569 A1 offenbart eine Sputtervorrichtung, die vorwiegend zur Herstellung eines dünnen dielektrischen Films für eine optische Vorrichtung verwendet wird, einen Mischfilm, der mit einer solchen Sputtervorrichtung erzeugt wird, und einen Mehrschichtfilm, der den Mischfilm umfasst.

Vergöhl, M. et al. (Proceedings of Spie, Bd. 8450, S. 84502J, ISSN: 0277-786X) offenbart eine rechnerische und experimentelle Optimierung der Homogenität von Magnetron-zerstäubten optischen Präzisionsbeschichtungen.

Die US 2012/228122 A1 offenbart eine Zerstäubungsvorrichtung, die einen in einer Vakuumkammer angeordneten Targethalter, ein Target, einen in der Vakuumkammer angeordneten Substrathalter, der das Substrat trägt, und einen Verschluss, der zwischen dem Targethalter und dem Substrathalter angeordnet ist, wobei der Verschluss den Substrathalter und den Targethalter voneinander abschirmen kann.

Die EP 2 549 521 A1 offenbart Verfahren und Vorrichtungen zur Herstellung einer oder mehrerer partikelarmer Schichten auf Substraten im Vakuum, wobei die Schichten aus zyklischem Quellmaterial durch Magnetron-Zerstäubung und entgegen der Schwerkraft auf das Substrat aufgebracht werden.

Badeen, A. et al. (Proceedings of Spie, Bd. 7101, S. 71010H, ISSN: 0277-786X) offenbaren fortgeschrittene optische Beschichtungen für Anwendungen in der Telekommunikation und der Spektroskopie.

Ausgehend hiervon war es Aufgabe der vorliegenden Erfindung, ein Verfahren zur Herstellung uniformer Schichten bereitzustellen, das einen stabilen Abscheideprozess bei möglichst hohem Durchsatz ermöglicht.

Diese Aufgabe wird durch das Verfahren mit den Merkmalen des Anspruchs 1 und die Vorrichtung mit den Merkmalen des Anspruchs 8 gelöst. Die weiteren abhängigen Ansprüche zeigen vorteilhafte Weiterbildungen auf.

Erfindungsgemäß wird ein Verfahren zur Herstellung uniformer Schichten auf bewegten Substraten in einer Vakuumkammer durch Abscheidung von mindestens einem Quellmaterial mittel Magnetronzerstäubung bereitgestellt, bei dem mindestens ein Substrat mit mindestens einer beweglichen Substrathalterung in der Vakuumkammer zu mindestens einer Sputterzone transportiert wird und in der Sputterzone mindestens eine Schicht aus Quellmaterial durch Sputtern des das Quellmaterial enthaltenden Targets auf dem Substrat abgeschieden wird. Das erfindungsgemäße Verfahren zeichnet sich dabei dadurch aus, dass das Quellmaterial ohne separate Zufuhr eines Reaktionsgases in die Vakuumkammer abgeschieden wird. Hierbei kann zunächst eine dünne, unterstöchiometrische Schicht abgeschieden werden, die in einem nächsten Schritt in einer Oxidationszone voll durchoxidiert werden kann. Das erfindungsgemäße Verfahren ist dadurch gekennzeichnet, dass alle Flächen, die sich im Bereich der mindestens einen Sputterzone befinden, aus dem mindestens einen Quellmaterial bestehen.

Erfindungsgemäß wird dazu ein Substrat in einer schnellbewegten Anordnung zwischen Beschichtungs- und Oxidationszone hin und her bewegt, so dass bevorzugt jeweils nur eine sehr dünne Schicht von weniger als 1 nm zu oxidieren ist. Die Oxidation kann durch Sauerstoff alleine, oder auch durch eine Sauerstoff-Plasmaquelle wie in der obigen US 5,798,027 (OCLI) Patentschrift erfolgen.

Bevorzugt kommen zylindrische Sputtertargets zum Einsatz, die besonders sauber bleiben, da sie keine Rückbeschichtungsbereiche auf dem Target hinterlassen. Besonders in reaktiven Beschichtungsprozessen (mit z.B. Sauerstoff oder Stickstoff als Reaktivgas) bilden sich auf Planarkathoden solche Rückbeschichtungsbereiche aus Metalloxiden (oder - Nitriden), die eine Quelle für Partikel darstellen. Daher ermöglicht die Verwendung von zylindrischen Targets einen sehr sauberen Beschichtungsprozess. Wahlweise kann ein Einzel- oder auch ein Doppelmagnetron eingesetzt werden. Bevorzugt soll ein gepulster Sputterprozess zum Einsatz kommen.

Im Gegensatz zum Stand der Technik wird bei dem erfindungsgemäßen Ansatz keine zusätzliche gasförmige Reaktivkomponente im Prozessraum zugesetzt.

Das Sputtertarget besteht bevorzugt aus einem Target, das bereits wesentliche Mengen des Reaktivgases enthält. Denkbar ist als Quellmaterial hier ein keramisches Material der Form MeOₓ. Ist die Schicht in der Form MeOz mit Me= Ti, Si, Zr, Hf stöchiometrisch, so kann hierbei Target die Zusammensetzung MeOₓ mit x = 0.5 bis 2 aufgebracht werden, vorzugsweise mit einem möglichst hohen x, wobei das Target aber eine elektrische Leitfähigkeit haben soll. Entsprechendes gilt für Schichten der Form Me₂O₃ im Falle von Aluminium oder Me₂O₅ im Falle von Tantal oder Niob. Eine hohe elektrische Leitfähigkeit ist notwendig, um elektrische Bogenentladungen zu vermeiden und einen stabilen Sputterbetrieb des Targets zu ermöglichen. Hier kann es sinnvoll sein, dass das Target nicht vollstöchiometrisch ist, sondern metallische Anteile zum Oxid verwendet werden. Die Herstellung des Targets kann beispielsweise durch thermisches Spritzen geschehen, wo durch Zugabe von metallischem Pulver zum Oxidpulver eine elektrische Leitfähigkeit des Targets erreicht wird, so dass der Sputterprozess auch mit DC oder Mittelfrequenz-Anregung betrieben werden kann.

Die Reaktivgaskomponente kann bereits im Quellmaterial eingebaut sein (z.B. Nb₂Oₓ, Ta₂Oₓ, TiOₓ, HfOₓ, ZrOₓ etc.) und führt bereits während der Deposition der Schicht auf dem Bauteil zur Bildung eines substöchiometrischen Films.

Diese Schicht lässt sich nun besonders stabil herstellen, da die Sputterkathode gleichmässig aus demselben Material besteht und die Oberfläche, da auch immer das gleiche Material in konstanter Zusammensetzung gesputtert wird, stets die gleiche Stöchiometrie besitzt. Dies führt zu einer besonders stabilen Sputterausbeute und damit Beschichtungsrate über das Target hinweg. Im Falle einer metallischen Kathode besteht die Gefahr, dass sich eine Unsymmetrie der Bedeckung mit einer (Sub-)Oxidschicht aufbaut. Denn sobald auf einer Targetseite eine Oxidschicht entsteht, reduziert sich dort die Sputterrate, so dass dort der Sauerstoffanteil noch mehr ansteigt. Dies reduziert somit weiterhin die Beschichtungsrate, was zu einer immer größeren Asymmetrie der Entladung führen kann.

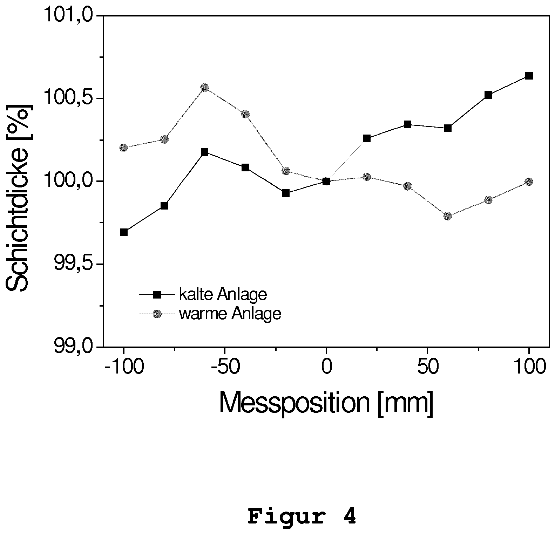

Zwar ist auch bei metallischen Targets dieser Effekt reduziert, wenn man den Prozess teilreaktiv betreibt, also eine Plasmaquelle zur Nachoxidation zur Hilfe nimmt, so dass dann der Reaktivgasgehalt gegenüber einem vollreaktiven Prozess reduziert werden kann. Allerdings ist besonders im Bereich sehr hoher Präzision und Uniformität (> 99%) eine Unsymmetrie möglich, weil die Sputterrate von der Oxidbedeckung stärker abhängig ist. Die Verteilung kann dann kippen, was in Fig. 4 dargestellt ist.

Es wurde jedoch überraschend gefunden, dass bei einem Metalloxid bzw. Halbmetalloxid enthaltenden Quellmaterial, dem Metall bzw. Halbmetall beigemischt wird, wesentlich höhere Abscheideraten erzielt werden können, wobei die Eigenschaften der gesputterten Schicht von gleicher Qualität sind (z.B. gleiche optische Qualität). Folglich macht die Verwendung dieses "Mischquellmaterials" das Gesamtverfahren deutlich ökonomischer.

Es ist daher bevorzugt, dass in dem erfindungsgemäßen Verfahren bzw. in der erfindungsgemäßen Vorrichtung das mindestens eine Quellmaterial eine Mischung aus
i) einem Metall und Metalloxid; oder
ii) einem Halbmetall und Halbmetalloxid; oder
iii) metallischen Mikrokristalliten und oxidischen, nidridischen oder fluoridischen Mikrokristalliten besteht,
enthält oder daraus besteht, wobei die Zusammensetzung bevorzugt MeO₂₋ₓ, Me₂O_{3-y} oder Me₂O_{5-z} mit Me = Ti, Zr, Nb, Hf, Si, Al, Ta, Sn, In, Y und/oder Mischungen davon, enthält oder daraus besteht, wobei ausgehend von der vollen Stöchiometrie der Wert x zwischen 0,5 und 1,5 beträgt, der Wert y zwischen 0,5 und 1,5 beträgt und der Wert z zwischen 0,5 und 2,5 beträgt, besonders bevorzugt der Wert x zwischen 0,75 und 1,25, der Wert y zwischen 0,75 und 1,25 und der Wert z zwischen 1 und 2 beträgt.

Um eine günstige Kombination aus hoher Rate und optimalen optischen Eigenschaften (geringe Absorption, geringe Streuung) zu erhalten beträgt der Metallanteil im Target soviel, dass ausgehend von der vollen Stöchiometrie (MeO₂₋ₓ, Me₂O_{3-y} bzw. Me₂O_{5-z}) der Wert x idealerweise zwischen 0,5 und 1,5 beträgt, der Wert y zwischen 0,5 und 1,5 beträgt und der Wert z zwischen 0,5 und 2,5 beträgt. Besonders bevorzugt liegt der Wert x zwischen 0,75 und 1,25, der Wert y zwischen 0,75 und 1,25 und der Wert z zwischen 1 und 2.

Bei zylindrischen Targets ist dieser Vorteil besonders groß, weil diese eine erheblich größere Fläche haben als planare Targets. Der Gettereffekt ist daher größer als bei zylindrischen Targets.

In einer bevorzugten Ausführungsform wird in dem erfindungsgemäßen Vorrichtung mindestens eine Plasmaquelle eingesetzt, um die mindestens eine Schicht aus mindestens einem Quellmaterial auf dem Substrat zu oxidieren, nitrieren und/oder fluorieren, bevorzugt mit einem Gas enthaltend oder bestehend aus Sauerstoff, Stickstoff und/oder einem Fluor-haltigen Gas, besonders bevorzugt dergestalt, dass substöchiometrisch oxidiertes, nitriertes und/oder fluoriertes Material der mindestens einen Schicht aus mindestens einem Quellmaterial auf dem Substrat zu stöchiometrisch oxidiertem, nitriertem und/oder fluoriertem Material oxidiert, nitriert und/oder fluoriert wird.

Auch kann erfindungsgemäß eine höhere Beschichtungsrate für die Herstellung optische Schichten mit geringen Absorptionsverlusten erreicht werden. Zwar lässt sich mit zylindrischen, metallischen Targets eine höhere Rate erreichen als mit einem reaktivgashaltigen Target, da die Sputterausbeute in der Regel höher ist. In diesem Fall muss jedoch die Rate so klein gewählt werden, dass die Plasma-Nachoxidation noch in der Lage ist, die Schicht vollständig zu oxidieren. Auch in diesem Fall jedoch sind optische Absorptionsverluste auch bei geringer Rate möglich. Bei zu hoher Rate werden die metallischen Schichten zu dick, als dass sie durchoxidiert werden können. Somit lassen sich nur bei sehr geringer Rate im Prozess transparente Schichten herstellen. Im erfindungsgemäßen Prozess wird mit hoher Stabilität bereits eine Oxidschicht mit einer Stöchiometrie nahezu der des Targets abgeschieden, so dass auch dickere Teilschichten durchoxidiert werden können.

Durch die erfindungsgemäße Verwendung eines aus Quellmaterial bestehenden Targets bleibt die Kathode darüber hinaus sauber und es bilden sich keine Rückbeschichtungsbereiche.

Der so entstandene, unterstöchiometrische Film wird an der Plasmaquelle nachoxidiert. Somit ist die Rate bzw. die Rotationsgeschwindigkeit des Substrats so einzustellen, dass nur eine dünne Schicht (1 bis 10 Atomlagen) oxidiert werden muss.

In der Optik werden in der Regel neben hochbrechenden Materialien (TiO₂, TazOs, CeOz, Y₂O₃, NbzOs etc.) auch niederbrechende Materialien eingesetzt. Diese sind in der Regel SiOz oder teilweise auch Al₂O₃.

Es besteht die Möglichkeit, dass ein Target der Form SiOₓ nicht leitfähig genug ist, um es mit Mittelfrequenztechnik (bis zu 300 KHz) einzusetzen. Anstelle dessen kann auch ein RF Prozess (13,56 MHz) zum Einsatz kommen. Die RF-Technik ist auch nutzbar für reine SiO₂-Targets (Quarz-Rohre), die dann fast vollstöchiometrisch gesputtert werden können. Mittels Plasma-Nachoxidation können optische Verluste weiter reduziert werden. Diese Variante hätte besondere Vorteile für anspruchsvolle Laserkomponenten (Laserspiegel), bei denen hohe Laserleistungen eingesetzt werden.

Auch Fluorid-Schichten können mit diesem Verfahren besonders günstig hergestellt werden, indem ein Fluorid-Target mittels RF gesputtert wird und eine Plasma-Fluorbehandlung mit einem CF₄-Gas durchgeführt wird. CF₄ ist sicherheitstechnisch weniger anspruchsvoll als reines Fluorgas. Mit diesem CF₄ können dann auch sehr verlustarme Schichten realisiert werden.

Auf der anderen Seite haben die Ergebnisse auch gezeigt, dass besonders bei hochbrechenden Materialien vorteilhafte Ergebnisse durch die vorliegende Erfindung erzielt werden können.

Ein Ansatz zur Erhöhung der Leitfähigkeit von SiOₓ-Targets aber auch darin bestehen, andere Stoffe in das Target hinein zu dotieren, so dass dieses wieder leitfähig wird. Denkbar sind solche Stoffe, die als Oxid wiederum Transparent und leitfähig sind, z.B. Ta, Nb, Al, Bor, Sn oder Zn. Dieses Verfahren kann auch bei anderen Targetmaterialien eingesetzt werden.

Denkbar ist beispielsweise auch die Möglichkeit, dass vollstöchiometrische Targets dotiert werden, so dass zwar keine metallischen Anteile im Target vorhanden sind, dennoch aber eine elektrische Leitfhähigkeit resultiert und die Vorteile der besonders hohen Stabilität und Uniformität genutzt werden können. In diesem Fall resultiert eine besonders gute Stöchiometrie der Schichten, da bereits die Schicht auch ohne zusätzliche Plasmaquelle fast stöchiometrisch abgeschieden werden kann. Mit einer nachfolgenden Plasmaoxidation kann die Stöchiometrie besonders gut erreicht werden, was besonder Vorteile für sehr anspruchsvolle Optiken wie Laserkomponenten hat, bei denen es auf sehr geringe optische Verluste ankommt.

Die Restleitfähigkeit kann beispielsweise mit einem Ohmmeter an einer Bruchkante gemessen werden.

Erfindungsgemäß besteht nicht nur das Target aus dem Quellmaterial, sondern auch alle Flächen, die sich im Bereich der Sputterzone (d.h. im Kompartment) befinden.

Eine bevorzugte Variante sieht vor, dass das Quellmaterial ein Reaktivgas aus der Gruppe bestehend aus Sauerstoff, Stickstoff und/oder Fluor enthält, das bevorzugt beim Sputtern "in-situ" in der Vakuumkammer freigesetzt.

Zwar ist bei einem keramischen, reaktivgashaltigen Target der Einfluss des Reaktivgas-Partialdruckes auf die Rate geringer als bei einem metallischen Target, jedoch ist hier noch ein wenn auch geringer Einfluss festzustellen, wenn sich im oder in der Nähe des Sputterbereichs Komponenten befinden, die Sauerstoff gettern können. Je nach Getterwirkung der Komponenten kann dies nämlich dazu führen, dass einzelne Teilbereiche unterschiedlich das Reaktivgas gettern, so dass es zu Schwankungen im Sauerstoff-Partialdruck kommen kann. Diese wiederum beeinflussen geringfügig die Rate auf dem Target. Hier kann es zu Unsymmetrien kommen, wenn sich z.B. metallische Teile mit hoher Getterwirkung an einem einen Ende des Targets befinden.

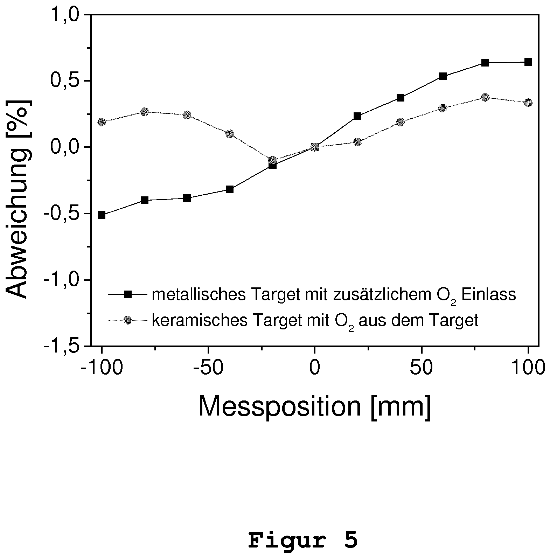

Erfindungsgemäß bestehen alle Oberflächen im Sputterkompartment aus dem Quellmaterial. Diese sind beispielsweise Abschirmbleche oder Korrekturblenden, wie man sie bei Drehtelleranlagen braucht, um die Schichtdickenverteilung auf dem Substrat zu korrigieren. Durch die Verwendung dieser Komponenten sowie dem reaktivgashaltigen Target ist es möglich, einen Drift in der Schichtdickenverteilung zu minimieren und eine sehr stabile und hohe Uniformität von besser als 99%, bevorzugt besser als 99.5%, besonders bevorzugt besser als 99,8% auf dem ganzen Substrat und auf allen Substraten des Batches zu erreichen (s. Fig. 5). Diese Uniformität kann gemessen werden mit Hilfe von mehreren optischen Sensoren, die z.B. die Transmission wellenlängenabhängig messen, woraus die Schichtdicke an verschiedenen Stellen des Substrates berechnet wird.

Bei Drehtelleranordnungen mit schneller Rotation (50 - 500 Umdrehungen pro Minute) hat sich eine Substratgröße zwischen 100 und 400 mm bewährt, bevorzugt 150-300 mm, besonders bevorzugt 180-250 mm.

Während in herkömmlichen Konstruktionen mit metallischen Oberflächen teilweise lang, d.h. Beschichtung über mehrere Stunden mit Schichtdicken von mehreren 1000 nm Schichtdicke auf dem Substrat konditioniert werden muss, kann bei richtiger Auswahl der Oberflächen eine kurze Konditionierung (weniger als 1000 nm abgeschiedene Schicht) ausreichend sein.

Von Vorteil ist es auch hier, durch eine Konditionierung für eine konstante Temperatur aller Oberflächen zu sorgen, denn unterschiedliche Temperaturen führen zu lokal unterschiedlicher Getterwirkung der Oberflächen bzw. zu verändertem Reaktivgas-Partialdruck. Idealerweise sollten sich daher alle Teile auf gleicher Temperatur befinden.

Auch hier führt die Verwendung von Quellmaterial enthaltenden Targets und/oder von Quellmaterial enthaltenden Komponenten in der Prozesskammer dazu, dass eine schnelle Konditionierung erreicht wird. Auch hier lässt sich die gute Konditionierung messen über die Messung der Uniformität mittels Transmissionsmonitor. So kann die Dauer der Konditionierung, die gemäß Verfahren des Standes der Technik ca. 10 h beträgt, beim erfindungsgemäßen Verfahren auf 1 bis 2 h reduziert werden.

Eine weitere bevorzugte Ausführungsform sieht vor, dass mindestens eine Plasmaquelle zur Temperierung des Substrates, zur Reinigung des Substrats, insbesondere durch Abbau organischer Kontamination auf dem Substrat, zur Aktivierung der Oberfläche des Substrates, zur Modifizierung der Struktur und/oder Stöchiometrie der Schicht und/oder zur Einstellung der intrinsischen Spannung der Schicht eingesetzt wird.

Die Modifizierung der Stöchiometrie der Schicht ist dann erforderlich, wenn beim Sputtern unterstöchiometrische Schichten abgeschieden werden, z.B. eine Schicht von TiO_{1,9}, die nachträglich mittels einer Plasmaquelle nachoxidiert werden muss, um die gewünschte Stöchiometrie, z.B. TiO₂, zu erhalten.

Vorzugsweise beträgt der Prozessdruck in der Vakuumkammer von 3 × 10⁻⁴ bis 5 × 10⁻² mb.

Die Magentronzerstäubung kann mit einer Gleichstromversorung (DC), einer gepulsten Gleichstromversorgen durch Hochleistungsimpulsmagentronsputtern (HIPIMS) oder durch Mittelfrequenz- oder RF-Entladungen betrieben werden.

Eine weitere erfindungsgemäße Variant sieht vor, dass die Dicke der Schicht auf dem Substrat durch eine der folgenden Messungen kontrolliert wird.
optisches Transmissionsmonitoring, optional über polarisierte Transmissionsmessungen bei schrägem Einfallswinkel,
optisches Reflexionsmonitoring, optional über polarisierte Reflexionsmessungen bei schrägem Einfallswinkel,
optisches Absorptionsmonitoring,
Ellipsometrie bei einer Wellenlänge oder über einen Spektralbereich sowie Schwingquarzmessung.

Erfindungsgemäß wird ebenso eine Vorrichtung zur Herstellung uniformer Schichten auf bewegten Substraten im Vakuum durch Abscheidung von mindestens einem Quellmaterial mittels Magentronzerstäubung bereitgestellt, das eine Vakuumkammer mit mindestens einer Sputterzone enthält, der mindestens eine Magentron-Sputtereinrichtung mit mindestens einem das Quellmaterial enthaltenden Target angeordnet ist, wobei in der Vakuumkammer mindestens eine bewegliche Substrathalterung für den Transport mindestens eines Substrates zu der mindestens einen Sputterzone angeordnet ist. Das erfindungsgemäße Quellmaterial ist ein Material, das keine separate Zufuhr eines Reaktionsgases in die Vakuumkammer erforderlich macht.

Erfindungsgemäß bestehen alle Flächen, die sich im Bereich der Sputterzone befinden, aus dem mindestens einen Quellmaterial, was zur Verkürzung der Konditionierungsphase führt. Hinsichtlich der Materialien wird auf die beim zuvor beschriebenen Verfahren genannten Quellmaterialien aus Sauerstoff-Stickstoff und/oder Fluor enthaltenden Materialien verwiesen.

Die erfindungsgemäße Vorrichtung kann dadurch gekennzeichnet sein, dass sie, bevorzugt in der Vakuumkammer, mindestens eine Plasmaquelle enthält, wobei die Plasmaquelle so ausgerüstet und eingestellt ist, dass die Plasmaquelle mindestens eine Schicht aus mindestens einem Quellmaterial auf dem Substrat oxidiert, nitriert und/oder fluoriert, bevorzugt mit einem Gas enthaltend oder bestehend aus Sauerstoff, Stickstoff und/oder einem Fluor-haltigen Gas, besonders bevorzugt dergestalt, dass substöchiometrisch oxidiertes, nitriertes und/oder fluoriertes Material der mindestens einen Schicht aus mindestens einem Quellmaterial auf dem Substrat zu stöchiometrisch oxidiertem, nitriertem und/oder fluoriertem Material oxidiert, nitriert und/oder fluoriert wird.

Es wird ebenso ein beschichtetes Substrat bereitgestellt, dass gemäß dem zuvor beschriebenen Verfahren herstellbar ist.

Die erfindungsgemäß abgeschiedenen Substrate weisen vorzugsweise eine Uniformität von mindestens 99,9 %, bevorzugt von mindestens 99,5 % und besonders bevorzugt von mindestens 99,8 % auf.

Die Bestimmung der Uniformität erfolgte dabei nach der folgenden Methodik:
Die mechanische Schichtspannung wird mit einer optischen Technik gemessen werden. Dazu werden beschichtete 100 × 10 mm2 große Glassubstrate (Schott D263T) mit einer Dicke von 0,1 mm auf zwei Rasierklingen in definiertem Abstand abgelegt. Mit einem Laser-Abstandsmesser (MICRO-EPSILON optoNCDT ILD1400 series) wird die Krümmung der Gläser über Triangulation gemessen. Jede Probe wird 5 mal aufgelegt und gemessen, um den Messfehler zu reduzieren. Um den Einfluss der Gravitation auf die Messung zu reduzieren, werden beide Seiten der Probe vermessen.

Diese Messmethode wird näher beschrieben in "Stenzel, Olaf, Mark Schürmann, Steffen Wilbrandt, Norbert Kaiser, Andreas Tünnermann, Mathias Mende, Henrik Ehlers, Detlev Ristau, Stefan Bruns, Michael Vergöhl, Werner Riggers, Martin Bischoff und Mario Held: Optical and mechanical properties of oxide UV coatings, prepared by PVD techniques. Proceedings of the SPIE, Seite 81681W, 2011."

Weiterhin ist es bevorzugt, dass das Substrat aus einem bis 100°C, insbesondere bis 80°C thermisch stabilen Material besteht, insbesondere ein Kunststoff.

Ferner wird ein optischer Filter bestehend aus einer Abfolge von mindestens zwei alternierenden Schichten bereitgestellt, wobei die mindestens zwei alternierenden Schichten eine unterschiedliche Zusammensetzung aufweisen und herstellbar sind nach dem erfindungsgemäßen Verfahren. Insbesondere weist der optische Filter mindestens 120 alternierende Schichten und/oder eine Gesamtdicke von mindestens 6 µm auf. Die mindestens zwei alternierenden Schichten können zwei alternierende Substrate (d.h. zwei Schichten mit unterschiedlicher Zusammensetzung) enthalten oder daraus bestehen.

Anhand der nachfolgenden Figuren soll der erfindungsgemäße Gegenstand näher erläutert werden, ohne diesen auf die hier gezeigten spezifischen Ausführungsformen einschränken zu wollen.
Fig. 1 zeigt eine schematische Darstellung einer bevorzugten erfindungsgemäßen Vorrichtung ohne Drehteller in der Draufsicht.
Fig. 2 zeigt eine schematische Darstellung einer bevorzugten erfindungsgemäßen Vorrichtung mit Drehteller in der Draufsicht.
Fig. 3 zeigt eine schematische Darstellung einer bevorzugten erfindungsgemäßen Vorrichtung mit Drehteller in der Seitenansicht.
Fig. 4 zeigt anhand eines Diagramms einen Vergleich des Schichtdickenverlaufs.
Fig. 5 zeigt anhand eines Diagramms einen Vergleich des Schichtdickenverlaufs.
Fig. 6 zeigt gemessene Transmissionsschichten von TazOs-Schichten auf Quarz von zwei verschiedenen Target-Varianten.
Fig. 7 zeigt einen optischen Dünnschichtfilter, der mit einer der beiden Targetvarianten hergestellt wurde.

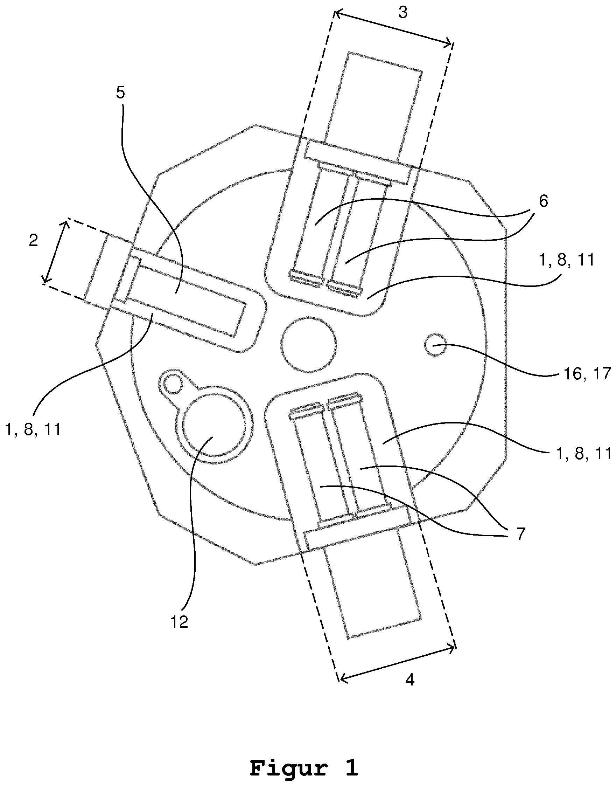

Figur 1 zeigt schematisch in der Draufsicht eine bevorzugte erfindungsgemäße Vorrichtung ohne Drehteller. Die Vorrichtung weist drei Magnetron-Sputtereinrichtungen 2, 3, 4 auf, wovon eine in der Einzelmagnetronanordung 2 und zwei in der Doppelmagnetronanordnung 3, 4 ausgestaltet sind. Die Magnetron-Sputtereinrichtungen 2 enthält eine Magnetron-Elektrode 5 und Sputtergas 11und befindet sich im Vakuum 1. Die Magnetron-Sputtereinrichtungen 3, 4 enthalten jeweils zwei Magnetron-Elektroden 6, 7 und Sputtergas 11und befinden sich im Vakuum 1. In der Nachbarschaft der Magnetron-Sputtereinrichtungen 2, 3, 4 befindet sich eine Plasmaquelle 12 und ein Photometer 16 und/oder eine Ellipsometrieflansche 17.

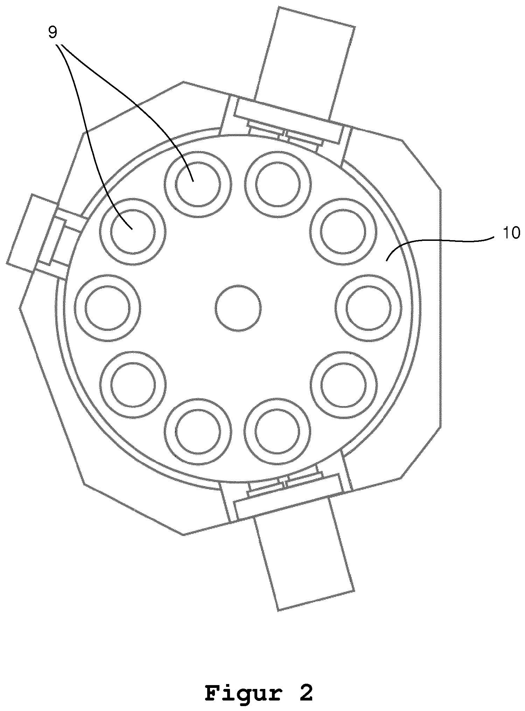

Figur 2 zeigt schematisch in der Draufsicht eine bevorzugte Ausgestaltung des Drehtellers. Der Drehteller 10 befindet sich in der Vorrichtung und weist in diesem Beispiel zehn identische Substrathalterungen 9 auf.

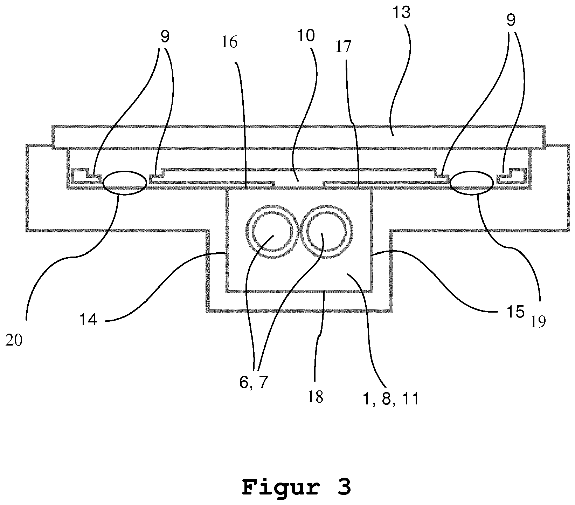

Figur 3 zeigt schematisch in der Seitenansicht eine bevorzugte Ausgestaltungsform der Vorrichtung mit Drehteller 10. Es ist der Querschnitt einer Magnetron-Sputtereinrichtung sichtbar, welche zwei Zylinder aus dem Quellmaterial 6, 7 enthält (Doppelmagnetronanordnung). Die Magnetron-Sputtereinrichtung ist an den Seiten von Begrenzungswänden 14, 15 und oben durch den Drehteller 10 gasdicht vom Rest der Vorrichtung abgegrenzt, enthält Sputtergas 11 und ist unter Vakuum 1. Zwei Substrathalterungen 9 des Drehtellers 10 sind in dem Querschnitt dargestellt bzw. sichtbar. Oberhalb des Drehtellers 10 befindet sich ein Deckel 13, welcher mit Begrenzungswänden, welche sich seitlich des Drehtellers 10 befinden, die Vorrichtung gasdicht abschließt.

Erfindungsgemäß bestehen nicht nur die Targets aus dem Quellmaterial, sondern auch alle Flächen, die sich im Bereich der mindestens einen Sputterzone befinden.

Zusätzlich zu den Blenden 16, 17 besteht die gesamte innere Oberfläche der Magnetron-Sputtereinrichtung, das sind die Begrenzungswände 14, 15 und die untere Wand 18, aus dem Quellmaterial.

Ferner weist zusätzlich zu der gesamten inneren Oberfläche der Magnetron-Sputtereinrichtung auch die der Magnetron-Sputtereinrichtung zugewandte Oberfläche des Drehtellers 10 eine Oberfläche aus dem Quellmaterial auf.

Eine weitere Variante sieht vor, dass unterhalb Substrathalterungen 9 in den Bereichen 19, 20 jeweils eine Shaperblende (nicht dargestellt in Fig. 3) angeordnet ist, die in geringem Abstand zum Substrat, z. B. 2 mm, angeordnet sind.

Fig. 4 zeigt zwei Graphen, die den Verlauf der Schichtdicke, normiert auf die Mitte des Substrats, zeigen. Beide Graphen sind bei unterschiedlichen Anlagenzuständen (warm/kalt) aufgenommen. Da die Temperatur Einfluss auf das Getterverhalten besitzt und bei diesen Prozessen Reaktivgas genutzt wurde, kommt es zu unterschiedlichen Verteilungen.

Fig. 5 zeigt zwei Graphen, die die Abweichung der Schichtdicken, normiert auf die Mitte des Substrats, zeigen. Der Unterschied bezieht sich auf die unterschiedlichen Anlagenzustände warm und kalt. Hier wird ein metallisches Target mit einem keramischen Target verglichen. Die Abweichung der Uniformität kann um mehr als die Hälfte reduziert werden.

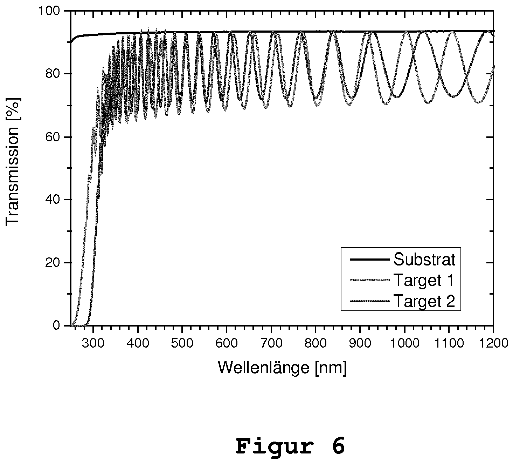

Fig. 6 zeigt gemessene Transmissionsspektren von ca. 2000 nm dicken TazOs-Schichten auf Quarz von zwei verschiedenen Target-Varianten. Das Target 1 ist ein Target mit einem Ta-Gewichtsanteil von 30% und einem Ta₂O₅-Gewichtsanteil von 70%, entsprechend einer Stöchiometrie Ta₂O_{3,3}. Bei dem Target 2 handelt es sich um ein Target in der Stöchiometrie von Ta₂O₄. Mit beiden Targets lassen sich unter Zuhilfenahme einer zusätzlichen Nachoxidation im Plasma Schichten mit guten optischen Eigenschaften, d.h. geringer Absorption, im sichtbaren Spektralbereich herstellen, wobei das Target 2 im sichtbaren Bereich eine noch höhere Transmission aufweist, daher also für besonders hochanspruchsvolle optische Komponenten besser geeignet ist. Durch Variation des Sauerstoffgehalts an der Plasmaquelle lässt sich allerdings auch die hier Transmission noch weiter verbessern. Das Target 1 hat eine größere Transparenz im UV-Bereich, was aber darin begründet ist, dass im Target 2 Dotierungen verwendet wurden, welche eine Verschiebung der Bandkante bewirken. Auch das Target 1 hat eine hohe Transmission und geringe optische Verluste im sichtbaren Spektralbereich. Der Vorteil ist bei Target 1, dass die Rate bei gleicher Leistung um 40% größer ist als bei dem vollstöchiometrischen Target. Da die Leistung sich, bedingt durch verfügbare Leistung am Generator, oder aber auch durch Materialbruch, nicht beliebig steigern lässt, ergibt sich dadurch auch ein Produktionsvorteil. Gegenüber einem vollstöchiometrischen Target hat auch das Target 2 in der Form Ta₂O_{3,3} den Vorteil einer erhöhten Beschichtungsrate.

Unabhängig von dieser speziellen Ausführungsform aus Figur 6 gilt, dass die Target durch verschiedene Arten hergestellt werden können. Denkbar sind beispielsweise Sinterprozesse oder auch thermisches Spritzen. Hierbei kann die Mikrostruktur der so hergestellten Targetmaterialien unterschiedlich sein, insbesondere kann sich die Korngröße unterscheiden. Möglich ist auch, dass sich eine Struktur ausbildet, bei der sowohl metallische Partikel oder Phasen neben oxidischen Partikeln oder Phasen in dem Targetmaterial zu finden sind. Die Größen dieser Strukturen können zwischen wenigen mm und mehreren 100 mm betragen. Auch in diesem Fall zeigt sich, dass die Prozessstabilität und auch die optische Qualität verbessert ist. Eine kleine Korngröße bzw. Größe der unterschiedlichen Phasen ist zu bevorzugen, besonders bevorzugt sind Abmessungen von weniger als 30 mm.

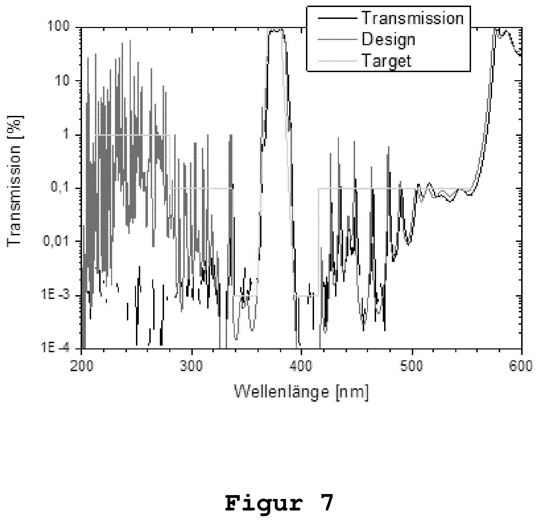

Figur 7 zeigt einen optischen Filter bestehend aus einem Multischichtsystem aus SiOz und TazOs, der mit einem erfindungsgemäßen Target, Variante 2 hergestellt wurde. Hierbei wurden insgesamt 120 Schichten bei einer Gesamtdicke von 6 µm verwendet. Der Filter hat einen schmalen Transmissionsbereich bei 375 nm und eine tiefe Blockung zwischen 200 und 550 nm. Hierbei ist die kürzere Bandkante bei dem Target 2 vorteilhaft, weil eine bessere Blockung unterhalb von 300 nm erreicht werden kann, zugleich aber eine höhere Transmission ab 330 nm als mit dem Target 1 erreicht wird.

## Patentansprüche

1. Verfahren zur Herstellung uniformer Schichten auf bewegten Substraten in einer Vakuumkammer durch Abscheidung von mindestens einem Quellmaterial mittels Magnetronzerstäubung, bei dem mindestens ein Substrat mit mindestens einer beweglichen Substrathalterung in der Vakuumkammer zu mindestens einer Sputterzone transportiert wird und in der Sputterzone mindestens eine Schicht aus mindestens einem Quellmaterial durch Sputtern des das mindestens eine Quellmaterial enthaltenden Targets auf dem Substrat abgeschieden wird,
wobei das mindestens eine Quellmaterial ohne separate Zufuhr eines Reaktionsgases in die Vakuumkammer abgeschieden wird,
**dadurch gekennzeichnet, dass** alle Flächen, die sich im Bereich der mindestens einen Sputterzone befinden, aus dem mindestens einen Quellmaterial bestehen.

2. Verfahren nach Anspruch 1, **dadurch gekennzeichnet, dass** die Konditionierung der Substrate bei einer Temperaturen von maximal 100°C, insbesondere maximal 50°C durchgeführt wird.

3. Verfahren nach einem der vorhergehenden Ansprüche, **dadurch gekennzeichnet, dass** die Schichten eine Uniformität von mindestens 99,0 %, bevorzugt von mindestens 99,5 %, besonders bevorzugt von mindestens 99,8 %, gemessen durch einen Laser-Abstandsmesser über Triangulation, wobei die Krümmung des Substrats gemessen wird, aufweisen.

4. Verfahren nach einem der vorhergehenden Ansprüche, **dadurch gekennzeichnet, dass** als bewegliche Substrathalterung ein rotierender Drehteller mit Aufnahmen für Substratträger eingesetzt wird, wobei der Drehteller bevorzugt mit einer Geschwindigkeit von 50 bis 500 rpm, besonders bevorzugt von 150 bis 500 rpm rotiert wird, so dass mit jeder Umdrehung des Drehtellers eine Schicht mit einer Schichtdicke von 0,03 bis 1 nm abgeschieden wird.

5. Verfahren nach einem der vorhergehenden Ansprüche, **dadurch gekennzeichnet, dass** mindestens eine Plasmaquelle eingesetzt wird,
a) um die mindestens eine Schicht aus mindestens einem Quellmaterial auf dem Substrat zu oxidieren, nitrieren und/oder fluorieren, bevorzugt mit einem Gas enthaltend oder bestehend aus Sauerstoff, Stickstoff und/oder einem Fluor-haltigen Gas, besonders bevorzugt dergestalt, dass substöchiometrisch oxidiertes, nitriertes und/oder fluoriertes Material der mindestens einen Schicht aus mindestens einem Quellmaterial auf dem Substrat zu stöchiometrisch oxidiertem, nitriertem und/oder fluoriertem Material oxidiert, nitriert und/oder fluoriert wird; und/oder
b) zur Temperierung des Substrats, zur Reinigung des Substrats, insbesondere durch Abbau organischer Kontaminationen auf dem Substrat, zur Aktivierung der Oberfläche des Substrates, zur Modifizierung der Struktur und/oder Stöchiometrie der Schicht und/oder zur Einstellung der intrinsischen Spannung der Schicht.

6. Verfahren nach einem der vorhergehenden Ansprüche, **dadurch gekennzeichnet, dass**
a) das Target zylindrisch oder planar ist; und/oder
b) der Prozessdruck in der Vakuumkammer in dem Bereich von 3·10⁻⁴ bis 5·10⁻² mbar liegt; und/oder
c) die Magnetronzerstäubung mit einer Gleichstromversorgung (DC), gepulsten Gleichstromversorgung (DC gepulst), HIPIMS, Mittelfrequenz- oder RF-Entladungen betrieben wird.

7. Verfahren gemäß einem der vorhergehenden Ansprüche, **dadurch gekennzeichnet, dass** zur Prozesskontrolle die Dicke der Schicht auf dem Substrat kontrolliert wird durch
a) optisches Transmissionsmonitoring, optional über polarisierte Transmissionsmessungen bei schrägem Einfallswinkel,
b) optisches Reflexionsmonitoring, optional über polarisierte Reflexionsmessungen bei schrägem Einfallswinkel,
c) optisches Absorptionsmonitoring,
d) Ellipsometrie bei einer Wellenlänge oder über einen Spektralbereich sowie
e) Schwingquarzmessung.

8. Vorrichtung zur Herstellung uniformer Schichten auf bewegten Substraten im Vakuum durch Abscheidung von mindestens einem Quellmaterial mittels Magnetronzerstäubung enthaltend eine Vakuumkammer mit mindestens einer Sputterzone, in der mindestens eine Magnetron-Sputtereinrichtung mit mindestens einem das mindestens eine Quellmaterial enthaltenden Target angeordnet ist, wobei in der Vakuumkammer mindestens eine bewegliche Substrathalterung für den Transport mindestens eines Substrates zu der mindestens einen Sputterzone angeordnet ist,
wobei das mindestens eine Quellmaterial ein Material ist, das keine separate Zufuhr eines Reaktionsgases in die Vakuumkammer erforderlich macht,
**dadurch gekennzeichnet, dass** alle Flächen, die sich im Bereich der mindestens einen Sputterzone befinden, aus dem mindestens einen Quellmaterial bestehen.

9. Vorrichtung nach Anspruch 8, **dadurch gekennzeichnet, dass** die mindestens eine bewegliche Substrathalterung ein rotierender Drehteller mit Aufnahmen für Substratträger ist und/oder das Target zylindrisch oder planar ist.

10. Vorrichtung nach einem der Ansprüche 8 oder 9, **dadurch gekennzeichnet, dass** in der Vakuumkammer mindestens eine Plasmaquelle
a) zur Temperierung des Substrates, zur Reinigung des Substrats, zur Aktivierung der Oberfläche des Substrates, zur Modifizierung der Struktur und/oder Stöchiometrie der Schicht und/oder zur Einstellung des intrinsischen Spannung der Schicht angeordnet ist; und/oder
b) enthalten ist, wobei die Plasmaquelle so ausgerüstet und eingestellt ist, dass sie mindestens eine Schicht aus mindestens einem Quellmaterial auf dem Substrat oxidiert, nitriert und/oder fluoriert, bevorzugt mit einem Gas enthaltend oder bestehend aus Sauerstoff, Stickstoff und/oder einem Fluor-haltigen Gas, besonders bevorzugt dergestalt, dass substöchiometrisch oxidiertes, nitriertes und/oder fluoriertes Material der mindestens einen Schicht aus mindestens einem Quellmaterial auf dem Substrat zu stöchiometrisch oxidiertem, nitriertem und/oder fluoriertem Material oxidiert, nitriert und/oder fluoriert wird.

11. Vorrichtung nach einem der Ansprüche 8 bis 10, **dadurch gekennzeichnet, dass** in der Vakuumkammer mindestens eine Vorrichtung zur Messung der Schichtdicke der abgeschiedenen Schicht auf dem Substrat, insbesondere ein optischer Transmissionsmonitor, Reflexionsmonitor oder Absorptionsmonitor, ein Ellipsometer bei einer Wellenlänge oder über einen Spektralbereich, eine Vorrichtung zur Schwinquarzmessung sowie Kombinationen hiervon, angeordnet ist.

## Claims

1. Method for the production of uniform films on moving substrates in a vacuum chamber by deposition of at least one source material by means of magnetron sputtering, in which at least one substrate is transported with at least one movable substrate mounting in the vacuum chamber to at least one sputtering zone and, in the sputtering zone, at least one film made of at least one source material is deposited on the substrate by sputtering the target comprising the at least one source material,
wherein the at least one source material is deposited without separate supply of a reaction gas into the vacuum chamber,
**characterised in that** all surfaces which are situated in the region of the sputtering zone consist of the at least one source material.

2. Method according to claim 1, **characterised in that** the conditioning of the substrate is implemented at a temperature of at most 100°C, in particular at most 50°C.

3. Method according to one of the preceding claims, **characterised in that** the films have a uniformity of at least 99.0%, preferably of at least 99.5%, particularly preferably of at least 99.8%, measured by a laser distance meter via triangulation, wherein the curvature of the substrate is measured.

4. Method according to one of the preceding claims, **characterised in that**, as movable substrate mounting, a rotating rotary table with receiving means for substrate carriers is used, the rotary table being rotated preferably at a speed of 50 to 500 rpm, particularly preferably of 150 to 500 rpm, so that, with each rotation of the rotary table, a film with a film thickness of 0.03 to 1 nm is deposited.

5. Method according to one of the preceding claims, **characterised in that** at least one plasma source is used
a) in order to oxidise, nitride and/or fluorinate the at least one film made of at least one source material on the substrate, preferably with a gas comprising or consisting of oxygen, nitrogen and/or a fluorine-containing gas, particularly preferably such that substoichiometrically oxidised, nitrided and/or fluorinated material of the at least one film made of at least one source material on the substrate is oxidised, nitrided and/or fluorinated to form stoichiometrically oxidised, nitrided and/or fluorinated material; and/or
b) for tempering the substrate, for cleaning the substrate, in particular by decomposition of organic contamination on the substrate, for activating the surface of the substrate, for modifying the structure and/or stoichiometry of the film and/or for adjusting the intrinsic stress of the film.

6. Method according to one of the preceding claims, **characterised in that**
a) the target is cylindrical or planar; and/or
b) the process pressure in the vacuum chamber is in the range of 3·10⁻⁴ to 5·10⁻² mbar; and/or
c) the magnetron sputtering is operated with a direct current supply (DC), pulsed direct current supply (DC pulsed), HIPIMS, medium frequency- or RF discharges.

7. Method according to one of the preceding claims, **characterised in that**, for process control, the thickness of the film on the substrate is controlled by
a) optical transmission monitoring, optionally via polarised transmission measurements at an acute angle of incidence,
b) optical reflection monitoring, optionally via polarised reflection measurements at an acute angle of incidence,
c) optical absorption monitoring,
d) ellipsometry at a wavelength or over a spectral range, and also
e) oscillator quartz measurement.

8. Device for the production of uniform films on moving substrates in a vacuum by deposition of at least one source material by means of magnetron sputtering, comprising a vacuum chamber with at least one sputtering zone in which at least one magnetron sputtering device with at least one target comprising the at least one source material is disposed, wherein at least one movable substrate mounting for transport of at least one substrate to the at least one sputtering zone is disposed in the vacuum chamber,
wherein the at least one source material is a material which does not require separate supply of a reaction gas into the vacuum chamber,
**characterized in that** all surfaces which are situated in the region of the sputtering zone consist of the at least one source material.

9. Device according to claim 8, **characterised in that** the at least one movable substrate mounting is a rotating rotary table with receiving means for substrate carriers and/or the target is cylindrical or planar.

10. Device according to one of the claims 8 or 9, **characterised in that**, in the vacuum chamber, at least one plasma source
a) is disposed for tempering the substrate, for cleaning the substrate, for activating the surface of the substrate, for modifying the structure and/or stoichiometry of the film and/or for adjusting the intrinsic stress of the film; and/or
b) is comprised, wherein the plasma source is equipped and adjusted such that it oxidises, nitrides and/or fluorinates at least one film made of at least one source material on the substrate, preferably with a gas comprising or consisting of oxygen, nitrogen and/or fluorine-containing gas, particularly preferably such that substoichiometrically oxidised, nitrided and/or fluorinated material of the at least one film made of at least one source material on the substrate is oxidised, nitrided and/or fluorinated to form stoichiometrically oxidised, nitrided and/or fluorinated material.

11. Device according to one of the claims 8 to 10, **characterised in that**, in the vacuum chamber, at least one device for measuring the film thickness of the deposited film on the substrate is disposed, in particular an optical transmission monitor, reflection monitor or absorption monitor, an ellipsometer at a wavelength or via a spectral range, a device for oscillator quartz measurement and also combinations hereof.

## Revendications

1. Procédé pour production de couches uniformes sur des substrats en mouvement dans une chambre à vide par dépôt d'au moins un matériau source par pulvérisation magnétron, dans lequel au moins un substrat est transporté avec au moins un support de substrat mobile dans la chambre à vide vers au moins une zone de pulvérisation et dans la zone de pulvérisation, au moins une couche constituée d'au moins un matériau source est déposée sur le substrat par pulvérisation de la cible contenant le au moins un matériau source,
dans lequel le au moins un matériau source est déposé dans la chambre à vide sans alimentation séparée d'un gaz de réaction,
**caractérisé en ce que** toutes les surfaces situées dans le secteur de la au moins une zone de pulvérisation sont constituées du au moins un matériau source.

2. Procédé selon la revendication 1, **caractérisé en ce que** le conditionnement des substrats est effectué à une température maximale de 100°C, en particulier maximale de 50°C.

3. Procédé selon l'une quelconque des revendications précédentes, **caractérisé en ce que** les couches présentent une uniformité d'au moins 99,0 %, de préférence d'au moins 99,5 %, de manière particulièrement préférée d'au moins 99,8 %, mesurée par un télémètre laser par triangulation, dans lequel la courbure de le substrat est mesurée.

4. Procédé selon l'une quelconque des revendications précédentes, **caractérisé en ce qu'**est utilisé comme support de substrat mobile un plateau tournant avec des logements pour porte-substrats, dans lequel le plateau tournant tourne de préférence à une vitesse de 50 à 500 tr/min, de manière particulièrement préférée de 150 à 500 tr/min, de sorte qu'à chaque tour du plateau tournant, une couche d'une épaisseur de couche de 0,03 à 1 nm est déposée.

5. Procédé selon l'une quelconque des revendications précédentes, **caractérisé en ce qu'**au moins une source de plasma est utilisée,
a) afin d'oxyder, nitrurer et/ou fluorer la au moins une couche d'au moins un matériau source sur le substrat, de préférence avec un gaz contenant ou constitué d'oxygène, d'azote et/ou un gaz contenant du fluor, de manière particulièrement préférée de telle manière que le matériau sous-stoechiométriquement oxydé, nitruré et/ou fluoré de la au moins une couche d'au moins un matériau source sur le substrat est oxydé, nitruré et/ou fluoré en un matériau stoechiométriquement oxydé, nitruré et/ou fluoré ; et ou
b) pour commander la température du substrat, pour nettoyer le substrat, notamment par décomposition de contaminations organiques sur le substrat, pour activer la surface du substrat, pour modifier la structure et/ou la stoechiométrie de la couche et/ou pour ajuster la tension intrinsèque de la couche.

6. Procédé selon l'une quelconque des revendications précédentes, **caractérisé en ce que**
a) la cible est cylindrique ou plane ; et ou
b) la pression de processus dans la chambre à vide est comprise entre 3-10⁻⁴ et 5-10⁻² mbar ; et ou
c) la pulvérisation magnétron fonctionne avec une alimentation en courant continu (CD), une alimentation en courant continu pulsé (CD pulsé), HIPIMS, des décharges moyenne fréquence ou radiofréquence, RF.

7. Procédé selon l'une quelconque des revendications précédentes, **caractérisé en ce que** pour la commande du processus, l'épaisseur de la couche sur le substrat est commandée par
a) a) surveillance de transmission optique, facultativement via des mesures de transmission polarisées selon un angle d'incidence oblique,
b) surveillance de réflexion optique, facultativement via des mesures de réflexion polarisée selon un angle d'incidence oblique,
c) surveillance d'absorption optique,
d) ellipsométrie à une longueur d'onde ou sur une plage spectrale
e) ainsi que mesure à quartz oscillant.

8. Dispositif pour production de couches uniformes sur des substrats en mouvement sous vide par dépôt d'au moins un matériau source par pulvérisation magnétron, contenant une chambre à vide avec au moins une zone de pulvérisation, dans laquelle est agencé au moins un dispositif de pulvérisation magnétron avec au moins une cible contenant le au moins un matériau source, dans lequel est agencé dans la chambre à vide au moins un support de substrat mobile pour le transport d'au moins un substrat vers la zone de pulvérisation,
dans lequel le au moins un matériau source est un matériau qui ne nécessite pas d'alimentation séparée d'un gaz de réaction dans la chambre à vide,
**caractérisé en ce que** toutes les surfaces situées dans le secteur de la au moins une zone de pulvérisation sont constituées du au moins un matériau source.

9. Dispositif selon la revendication 8, **caractérisé en ce que** le au moins un support de substrat mobile est un plateau tournant avec des logements pour des porte-substrats et/ou la cible est cylindrique ou plane.

10. Dispositif selon l'une quelconque des revendications 8 ou 9, caractérisé en ce dans la chambre à vide est agencée et/ou est incluse
a) au moins une source de plasma pour commander la température du substrat, pour nettoyer le substrat, pour activer la surface du substrat, pour modifier la structure et/ou la stoechiométrie de la couche et/ou ajuster la tension intrinsèque de la couche ; et ou
b) dans lequel la source de plasma est conçue et ajustée de manière à oxyder, nitrurer et/ou fluorer au moins une couche d'au moins un matériau source sur le substrat, de préférence avec un gaz contenant ou constitué d'oxygène, d'azote et/ou un gaz contenant du fluor, de manière particulièrement préférée, de telle manière que le matériau sous-stoechiométriquement oxydé, nitruré et/ou fluoré de la au moins une couche d'au moins un matériau source sur le substrat est oxydé, nitruré et/ou fluoré en un matériau stoechiométriquement oxydé, nitruré et/ou fluoré.

11. Dispositif selon l'une quelconque des revendications 8 à 10, **caractérisé en ce que** dans la chambre à vide est agencée au moins un dispositif pour mesurer l'épaisseur de couche de la couche déposée sur le substrat, en particulier un moniteur de transmission optique, un moniteur de réflexion ou un moniteur d'absorption, un ellipsomètre à une longueur d'onde ou sur une plage spectrale, un dispositif de mesure à quartz oscillant et des combinaisons de ceux-ci.
